# EUROPÄISCHE PATENTANMELDUNG

(11) **EP 4 847 661 A1**
(43) Veröffentlichungstag der Anmeldung: **02.12.2026**
(21) Anmeldenummer: 26179138.8
(22) Anmeldetag: 18.05.2026
(51) Int. Cl.: C23C 14/56, C21D 8/02, C21D 8/0278, C21D 9/46, C23C 14/02, C23C 14/54

(54) **PRODUKTIONSANLAGE UND VERFAHREN ZUR PVD-BESCHICHTUNG VON GEBEIZTEM WARMBAND**

(30) Priorität: 27.05.2025 EP 25179140
(71) Anmelder: ThyssenKrupp Steel Europe AG, 47166 Duisburg (DE)
(72) Erfinder: Junge, Dr. Fabian, 47166 Duisburg (DE); Lohmeyer, Niels, 47166 Duisburg (DE); Strack, Michael, 47166 Duisburg (DE)
(74) Vertreter: ThyssenKrupp Steel Europe AG

(57) **Zusammenfassung**

Die Erfindung betrifft eine Produktionsanlage zur Herstellung von beschichtetem Warmband und ein Verfahren zum Herstellen von beschichtetem Warmband. Die Produktionsanlage zur Herstellung von beschichtetem Warmband (3), umfassend:
a) optional eine Warmband-Produktionslinie (1) zur Erzeugung von Warmband (3),
b) eine Beize (5) zur Entfernung von Oxidschichten und Verunreinigungen von der Oberfläche des Warmbands (3),
c) eine PVD-Beschichtungsanlage (7) zur Aufbringung einer Beschichtung auf das Warmband (3) mit einer Einlauf-Vakuumschleuse (9),

ist dadurch gekennzeichnet, dass die Produktionsanlage eine durchgehende Bandführung durch die Beize (5) und die PVD-Beschichtungsanlage (7) aufweist. Das Verfahren zur Herstellung von beschichtetem Warmband (3), umfassend die Schritte:
d) Erzeugen von Warmband (3) in einer Warmband-Produktionslinie (1),
e) Beizen des Warmbands (3) zur Entfernung von Oxidschichten und Verunreinigungen von der Oberfläche,
f) Verbringen des Warmbandes (3) in einen Bereich mit reduziertem Druck (8) über eine Einlauf-Vakuumschleuse (9),
g) Beschichten des Warmbands (3) mittels Physical Vapor Deposition (PVD) in einer PVD-Beschichtungsanlage (7) umfassend die Einlauf-Vakuumschleuse (9),

ist dadurch gekennzeichnet, dass das Warmband (3) durchgehend durch die Beize (5) und die PVD-Beschichtungsanlage (7) geführt wird.

## Beschreibung

Die Erfindung betrifft eine Produktionsanlage zur Herstellung von beschichtetem Warmband und ein Verfahren zum Herstellen von beschichtetem Warmband.

Die Herstellung von Warmband erfolgt in einer Warmband-Produktionslinie. Eine solche Warmband-Produktionslinie kann als eine Warmbandstraße ausgebildet sein, die aus mehreren aufeinanderfolgenden Prozessschritten besteht. Zunächst wird das Vormaterial, meist in Form von Brammen, in einem Hubbalkenofen auf eine Temperatur von etwa 1200 °C erhitzt. Anschließend durchläuft das erhitzte Material eine Vorwalzstraße, in der es in mehreren Walzgerüsten zu einem dickeren Band ausgewalzt wird. Dieses Band wird dann in der Fertigwalzstraße weiter reduziert, wobei es durch eine Reihe von Walzgerüsten geführt wird, um die gewünschte Enddicke zu erreichen. Während des Walzprozesses wird das Band kontinuierlich mit Wasser gekühlt, um die Temperatur zu kontrollieren und die Materialeigenschaften zu verbessern. Typische Endwalztemperaturen liegen dabei zwischen 800 °C und 900 °C. Nach dem Walzen wird das Warmband auf einer Kühlstrecke weiter abgekühlt und schließlich auf Coils aufgewickelt, die zur Weiterverarbeitung bereitgestellt werden.

Alternativ kann eine Warmband-Produktionslinie als eine Gießwalzanlage ausgebildet sein. Dabei wird flüssiger Stahl zunächst in einer Gießeinrichtung zu einem Vorprodukt, insbesondere einem Dünnbrammenstrang oder Bandvorprodukt, vergossen. Das noch heiße Vorprodukt wird anschließend einer oder mehreren Walzeinrichtungen zugeführt, in denen es auf die gewünschte Banddicke reduziert wird. Gegebenenfalls erfolgt zwischen dem Gießen und dem Walzen sowie/oder nach dem Walzen eine Temperaturführung oder Kühlung, um die Materialeigenschaften einzustellen. Das so erzeugte Warmband wird anschließend weitergeführt und insbesondere zu Coils aufgewickelt, die zur Weiterverarbeitung bereitgestellt werden.

Vor der Weiterverarbeitung wird das Warmband in einer Durchlaufbeize behandelt, um den beim Warmwalzen entstandenen Zunder zu entfernen. Hierbei wird das Band durch ein Säurebad geführt, wobei häufig Schwefelsäure in Konzentrationen um 20 % und bei Temperaturen um 98 °C verwendet wird. Typische andere Säurebäder sind Schwefelsäure mit einer Konzentration von 230-290 g/I bei 80-90 °C oder 20 %-ige Salzsäure bei Temperaturen von 80-85 °C. Dieser Prozess sorgt für eine saubere metallische Oberfläche, die für nachfolgende Verarbeitungsschritte wie das Kaltwalzen oder Beschichten erforderlich ist. Nach dem Beizen wird das Warmband typischerweise wieder zu Coils gehaspelt.

Ein solches Warmband kann anschließend je nach Kundenwunsch und Anwendungszweck mit einer Beschichtung versehen werden. Typische Beschichtungsmethoden sind:
- Feuerbeschichten, bei dem das Warmband durch ein Bad aus dem geschmolzenen Beschichtungsmaterial (häufig Zink) geführt wird;
- Elektrolytisches Beschichten, bei dem die Beschichtung mittels elektrochemischer Prozesse aufgebracht wird;
- Coil Coating, bei dem das Warmband kontinuierlich mittels einer Auftragswalze mit einer Beschichtungsflüssigkeit benetzt wird. Beim Verdunsten des Lösungsmittels der Beschichtungsflüssigkeit verbleibt die Beschichtung (häufig: organische Beschichtungen) auf dem Warmband;
- PVD-Beschichtung, bei der das Warmband durch eine Vakuumkammer geführt wird, in der das Beschichtungsmaterial physikalisch verdampft wird und anschließend auf dem Warmband kondensiert.

Ein weiterer wichtiger Prozessschritt beim konventionellen Beschichten von Warmband ist das Reduktionsglühen unmittelbar vor dem Beschichten. Hierbei wird das Warmband in einer kontrollierten Atmosphäre erhitzt, um eine Reduktion der Oberflächenoxide zu bewirken und somit eine saubere und reaktive Oberfläche für die nachfolgende Beschichtung zu schaffen. Das Reduktionsglühen erfolgt typischerweise in einem kontinuierlichen Durchlaufofen, in dem das Warmband auf Temperaturen zwischen 600 °C und 900 °C erhitzt wird. Die Atmosphäre im Ofen besteht meist aus einem Gemisch von Wasserstoff und Stickstoff, das die Reduktion der Oberflächenoxide bewirkt.

Aufgabe der vorliegenden Erfindung ist die Bereitstellung einer Produktionsanlage und eines Verfahrens, bei denen ein gebeiztes Warmband mit geringem Anlagenaufwand in einen Bereich mit reduziertem Druck eingebracht und einer PVD-Beschichtung zugeführt werden kann.

Diese Aufgabe wird gelöst durch Verfahren zur Herstellung von beschichtetem Warmband. Dabei umfasst das Verfahren mindestens die folgenden Schritte:
a) Erzeugen von Warmband in einer Warmband-Produktionslinie,
b) Beizen des Warmbands zur Entfernung von Oxidschichten und Verunreinigungen von der Oberfläche,
c) Verbringen des Warmbandes in einen Bereich mit reduziertem Druck über eine Einlauf-Vakuumschleuse,
d) Beschichten des Warmbands mittels Physical Vapor Deposition (PVD) in einer PVD-Beschichtungsanlage, umfassend die Einlauf-Vakuumschleuse,
wobei das Warmband durchgehend durch die Beize und die PVD-Beschichtungsanlage geführt wird.

Bei der Warmband-Produktionslinie handelt es sich bevorzugt um eine Warmbandstraße. Alternativ ist die Warmband-Produktionslinie als eine Gießwalzanlage ausgebildet.

Unter dem durchgehenden Führen des Warmbandes ist zu verstehen, dass das Warmband ohne Unterbrechen des Bandlaufs und ohne Zwischenlagern des Warmbandes in Form von Coils geführt wird. Das Warmband wird also zwischen Beize und PVD-Beschichtungsanlage nicht gestoppt, sondern nahtlos in die PVD-Beschichtungsanlage geführt. Zwischen der Beize und der PVD-Beschichtungsanlage kann lediglich eine Anpassung der Bandgeschwindigkeit mittels eines Bandspeichers erfolgen. Es erfolgt kein Zerschneiden des Warmbandes zwischen diesen beiden Aggregaten.

Unter einem Bereich mit reduziertem Druck ist ein Bereich mit einer Atmosphäre zu verstehen, deren Druck mindestens 10 % geringer ist als die Normatmosphäre, d.h. 10 % geringer ist als 1 bar, bevorzugt geringer ist als 500 mbar.

Ebenso wird die Aufgabe gelöst durch eine Produktionsanlage zur Herstellung von beschichtetem Warmband. Die Produktionsanlage umfasst dabei:
a) Optional eine Warmband-Produktionslinie zur Erzeugung von Warmband,
b) eine Beize zur Entfernung von Oxidschichten und Verunreinigungen von der Oberfläche des Warmbands,
c) eine PVD-Beschichtungsanlage zur Aufbringung einer Beschichtung auf das Warmband mit einer Einlauf-Vakuumschleuse,
wobei die Produktionsanlage eine durchgehende Bandführung durch die Beize und die PVD-Beschichtungsanlage aufweist.

Unter einer durchgehenden Bandführung durch die Beize und die PVD-Beschichtungsanlage ist zu verstehen, dass Beize und PVD-Beschichtungsanlage eine gemeinsame unterbrechungsfreie Bandführung aufweisen. Somit wird das Warmband ohne Unterbrechen des Bandlaufs und ohne Zwischenlagern des Warmbandes in Form von Coils geführt. Zwischen der Beize und der PVD-Beschichtungsanlage ist also weder eine Schere zum Zerteilen des Bandes noch eine Haspel angeordnet. Das Warmband wird also zwischen Beize und PVD-Beschichtungsanlage nicht gestoppt, sondern nahtlos in die PVD-Beschichtungsanlage geführt. Zwischen der Beize und der PVD-Beschichtungsanlage können jedoch weitere Komponenten mit einer durchgehenden Bandführung, wie beispielsweise ein Bandspeicher, eine Messanordnung oder Systeme zur Steuerung des Bandlaufs angeordnet sein. Besonders bevorzugt sind keine weiteren Komponenten zwischen Beize und PVD-Beschichtungsanlage angeordnet, sondern die PVD-Beschichtungsanlage folgt unmittelbar auf die Beize.

Die durchgehende Bandführung von Beize und PVD-Beschichtungsanlage bietet mehrere entscheidende Vorteile, die die Effizienz und Qualität des gesamten Prozesses erheblich verbessern. Die kontinuierliche Bandführung ermöglicht einen nahtlosen Übergang des Warmbands von der Beize in die PVD-Beschichtungsanlage. Dieser nahtlose Übergang eliminiert Unterbrechungen im Prozessfluss, wodurch die Produktionszeit verkürzt und die Betriebseffizienz gesteigert wird. Durch die Vermeidung von Stillstandzeiten und die Reduzierung von Handhabungsaufwand wird die Gesamteffizienz der Anlage erheblich verbessert.

Da das Warmband in der Beize eine Temperatur von etwa 98 °C aufweist und nach dem Beizen nicht erst abgekühlt und zwischengelagert wird, ist kein Wiedererwärmen oder ein geringeres Wiedererwärmen für den anschließenden Beschichtungsprozess erforderlich. Das Einsparen bzw. Reduzieren des Wiedererwärmungsprozesses führt zu einer Reduzierung des Energieverbrauchs und der Betriebskosten, was die Wirtschaftlichkeit des Verfahrens erhöht und gleichzeitig den CO2-Fußabdruck der Anlage verringert. Ein geringerer Energieverbrauch bedeutet weniger CO2-Emissionen, was einen positiven Beitrag zum Umweltschutz und zur Nachhaltigkeit leistet.

Ein weiterer Vorteil der durchgehenden Bandführung ist, dass das Warmband zwischen der Beize und der PVD-Beschichtungsanlage nicht wesentlich oxidiert. Dies liegt daran, dass das Band kontinuierlich und ohne längere Exposition an die Atmosphäre von der Beize in die Beschichtungsanlage überführt wird. Dadurch kann auf ein Reduktionsglühen zum Entfernen der Oxidschicht vor dem Beschichten verzichtet werden, was den Prozess weiter vereinfacht und die Produktionskosten senkt. Das Ergebnis ist eine hochwertige Beschichtung ohne zusätzliche thermische Behandlungsschritte, was ebenfalls zur Energieeffizienz und zur Reduzierung des CO2-Fußabdrucks beiträgt.

Diese Vorteile machen die durchgehende Bandführung zu einer äußerst effizienten, kosteneffektiven und umweltfreundlichen Lösung für die Behandlung und Beschichtung von Warmband.

Bevorzugt umfasst die PVD-Beschichtungsanlage weiterhin eine Auslauf-Vakuumschleuse. Über die Auslauf-Vakuumschleuse wird das beschichtete Warmband aus dem Bereich mit reduziertem Druck in Umgebungsatmosphäre verbracht. Der Auslauf-Vakuumschleuse nachgelagert sind insbesondere ein Beölungsaggregat und ein Haspel angeordnet, um das beschichtete Warmband zu beölen und zu Coils aufzuhaspeln.

Bei einer bevorzugten Ausgestaltung ist die Produktionsanlage derart weitergebildet, dass die Produktionsanlage zwischen der Beize und der PVD-Beschichtungsanlage keine Glüheinheit umfasst. Unter einer Glüheinheit ist dabei ein Aggregat zu verstehen, das geeignet ist, Warmband im kontinuierlichen Durchlauf auf 500 °C oder mehr zu erhitzen. Auf ein derartiges Aggregat kann bevorzugt verzichtet werden, da in dem erfindungsgemäßen Prozess kein Reduktionsglühen vor der PVD-Beschichtung erforderlich ist. Somit kann eine effiziente Anlagenkonfiguration zur Verfügung gestellt werden, die wenig Komponenten enthält und damit kostengünstig und wartungsarm ist. Die Produktionsanlage ist somit derart weitergebildet, dass das Warmband zwischen der Beize und der PVD-Beschichtungsanlage mit maximal 300 °C, bevorzugt maximal 250 °C geführt wird. Die Bandführung zwischen Beize und PVD-Beschichtungsanlage ist demnach für Warmbänder mit maximal 300 °C, bevorzugt maximal 250 °C ausgelegt.

Beim Verfahren beträgt die Temperatur des Warmbands zwischen dem Beizen und dem Beschichten maximal 300 °C, bevorzugt maximal 250 °C. Zwischen dem Beizen und dem Beschichten findet also kein Zwischenglühen, insbesondere kein Reduktionsglühen statt. Somit hat der Prozess einen sehr niedrigen Energieverbrauch und ist ressourcenschonend. Weiterhin bevorzugt beträgt die Temperatur des Warmbands zwischen dem Beizen und dem Beschichten mindestens 40 °C, bevorzugt mindestens 60 °C, insbesondere mindestens 80 °C. Hierdurch wird erreicht, dass noch weiter Energie eingespart wird. Durch die Prozessführung wird eine Abkühlung des Warmbandes nach dem Beizen reduziert, so dass für den anschließenden Verfahrensschritt des Beschichtens keine oder nur eine geringe Wiedererwärmung des Warmbandes erforderlich wird.

Bevorzugt ist das Verfahren derart weitergebildet, dass die Zeitdauer, in der das Warmband vom Ende der Beize bis zur Einlauf-Vakuumschleuse der PVD-Beschichtungsanlage geführt wird, maximal 30 s, insbesondere maximal 20 s, bevorzugt maximal 10 s beträgt. Hierdurch wird erreicht, dass das Warmband nach dem Beizen nicht wesentlich abkühlen kann, bevor es die PVD-Beschichtungsanlage erreicht. Dies wiederum führt dazu, dass auf ein signifikantes Wiedererwärmen verzichtet werden kann. Weiterhin wird hierdurch erreicht, dass das gebeizte Warmband kaum oxidieren kann, bevor es in der PVD-Beschichtungsanlage beschichtet wird.

Die Produktionsanlage ist bevorzugt derart weitergebildet, dass der Abstand vom Ende der Beize bis zur Einlauf-Vakuumschleuse der PVD-Beschichtungsanlage, gemessen entlang des Warmbandes, maximal 100 m, bevorzugt maximal 70 m, insbesondere maximal 50 m, bevorzugt maximal 30 m, insbesondere maximal 20 m, besonders bevorzugt maximal 10 m beträgt. Hierdurch wird erreicht, dass das Warmband bei typischen Bandgeschwindigkeiten von 100 - 180 m/min diesen Abstand so zügig durchläuft, dass es nicht wesentlich abkühlen bzw. oxidieren kann.

Bei einer bevorzugten Ausgestaltung der Produktionsanlage umfasst diese einen Bandspeicher zwischen der Beize und einem Beschichtungsbereich der PVD-Beschichtungsanlage. Der Bandspeicher dient in dieser Konfiguration als prozesstechnisches Pufferaggregat, das es ermöglicht, die kontinuierliche Bandzufuhr aus der Beize aufrechtzuerhalten, auch wenn es im Bereich der physikalischen Gasphasenabscheidung (PVD) zu temporären Prozessunterbrechungen oder Taktzeitunterschieden kommt. Der Bandspeicher ist als vertikaler oder horizontaler Schlaufenpuffer ausgeführt, wobei das Band über eine Vielzahl von Umlenkrollen in mehreren Schlaufen geführt wird. Durch gezieltes Ein- und Ausfahren dieser Schlaufen kann der Bandspeicher Bandmaterial zwischenspeichern oder freigeben, ohne den kontinuierlichen Betrieb der Beize oder der PVD-Beschichtungsanlage zu beeinträchtigen. Dies ist insbesondere deshalb von Bedeutung, da die PVD-Beschichtung empfindlich auf Bandgeschwindigkeitsschwankungen reagiert und eine gleichmäßige Bandführung erfordert. Umgekehrt ermöglicht der Bandspeicher auch bei einer Unterbrechung oder einem kurzzeitigen Stillstand der Beize die kontinuierliche Versorgung der PVD-Beschichtungsanlage mit Bandmaterial aus dem Puffer. Der Bandspeicher trägt somit wesentlich zur Entkopplung der beiden Prozessschritte bei und gewährleistet eine stabile, qualitativ hochwertige Beschichtung des Warmbands bei gleichzeitig hoher Anlagenverfügbarkeit.

Der Bandspeicher kann entweder zwischen der Beize und der Einlauf-Vakuumschleuse oder zwischen der Einlauf-Vakuumschleuse und dem Beschichtungsbereich angeordnet sein. Der erstere Fall hat den Vorteil, dass der Bereich mit reduziertem Druck kleiner gehalten werden kann und zudem ermöglicht diese Konfiguration eine einfachere konstruktive Ausführung des Bandspeichers.

Bei einer bevorzugten Ausgestaltung der Produktionsanlage umfasst diese eine Heizeinheit, die zwischen der Einlauf-Vakuumschleuse und einem Beschichtungsbereich angeordnet ist, wobei die Heizeinheit insbesondere als Induktions-Heizeinheit, Infrarot-Heizeinheit, Elektronenstrahl-Heizeinheit, Plasma-Heizeinheit oder Strahlrohr ausgeführt ist oder mittels offener Flamme betrieben wird. Entsprechend ist das Verfahren bevorzugt so weitergebildet, dass das Band nach Durchlaufen der Einlauf-Vakuumschleuse auf eine Beschichtungstemperatur erwärmt wird, bevor es beschichtet wird.

Mittels der Heizeinheit kann das Warmband auf eine optimale Beschichtungstemperatur für den PVD-Beschichtungsprozess erwärmt werden. Diese Beschichtungstemperatur liegt im Bereich 100 °C bis 250 °C. Dies ist ein wenig höher als die typische Beiztemperatur von 98 °C. Die Anordnung zwischen der Einlauf-Vakuumschleuse und einem Beschichtungsbereich, d.h. stromabwärts der Einlauf-Vakuumschleuse, hat den Vorteil, dass das Warmband die Einlauf-Vakuumschleuse mit einer moderaten Temperatur unterhalb von 100 °C durchläuft. Dies ermöglicht den Einsatz einer barometrischen Flüssigkeitsschleuse als Einlauf-Vakuumschleuse. Eine solche barometrische Flüssigkeitsschleuse hat spezielle Vorteile, die später detailliert erläutert werden.

Eine Induktions-Heizeinheit nutzt elektromagnetische Induktion, um Wärme direkt im Metall zu erzeugen. Dies ermöglicht eine schnelle und effiziente Erwärmung des Warmbandes, da die Wärme direkt im Material erzeugt wird und somit keine Wärmeverluste durch Konvektion oder Strahlung auftreten. Zudem bietet die Induktionsheizung eine präzise Temperaturkontrolle und eine gleichmäßige Erwärmung, was die Qualität der Beschichtung verbessert.

Eine Infrarot-Heizeinheit erwärmt das Warmband durch Strahlungswärme, die direkt auf das Material übertragen wird. Diese Methode ist besonders effizient, da sie eine schnelle und gleichmäßige Erwärmung ermöglicht. Infrarot-Heizungen sind zudem einfach zu installieren und zu warten, und sie bieten eine hohe Energieeffizienz, da sie die Wärme gezielt auf das Warmband richten.

Eine Elektronenstrahl-Heizeinheit nutzt einen fokussierten Elektronenstrahl, um das Warmband zu erwärmen. Diese Methode bietet eine sehr hohe Leistungsdichte und ermöglicht eine präzise und schnelle Erwärmung des Materials. Elektronenstrahl-Heizungen sind besonders vorteilhaft für die Erwärmung von Materialien mit hoher Wärmeleitfähigkeit, da sie eine gleichmäßige Temperaturverteilung und minimale thermische Verzerrungen gewährleisten.

Eine Plasma-Heizeinheit nutzt ionisiertes Gas, um das Warmband zu erwärmen. Diese Methode bietet den Vorteil, dass sie bei relativ niedrigen Temperaturen arbeitet und somit besonders schonend für das Material ist. Plasma-Heizungen ermöglichen eine gleichmäßige Erwärmung.

Elektronenstrahl-Heizeinheiten und Plasma-Heizeinheiten benötigen für den Betrieb ebenfalls einen Bereich mit reduziertem Druck. Daher können diese auf einfache Weise im gleichen Bereich (d.h. ohne zwischengeschaltete Schleuse) betrieben werden wie die PVD-Beschichtung.

Beim Strahlrohr wird ein Gas-Luft-Gemisch innerhalb des Strahlrohres verbrannt. Diese Verbrennung des Gas-Luft-Gemisches erzeugt eine Flamme, die entlang der Innenwand des Strahlrohrs geführt wird. Die dabei entstehende Wärme wird durch Strahlung und Konvektion auf das umliegende Ofenmaterial sowie auf das vorbeigeführte Warmband übertragen. Die äußere Oberfläche des Strahlrohrs ist so gestaltet, dass sie eine maximale Abstrahlung bei gleichzeitig minimalem Wärmeverlust gewährleistet. Optional kann die Oberfläche mit einer hoch emittierenden Keramikbeschichtung versehen sein.

Ein wesentliches Merkmal des Strahlrohrs ist die Möglichkeit der individuellen Regelung jedes einzelnen Brenners. Dies erlaubt eine flexible Anpassung der Temperaturverteilung im Ofenraum an unterschiedliche Banddicken, Bandgeschwindigkeiten und Materialeigenschaften. Durch die gezielte Wärmeeinbringung wird eine homogene Temperaturverteilung im Warmband erreicht, was die Produktqualität verbessert und thermische Spannungen reduziert.

Darüber hinaus ermöglicht die Konstruktion des Strahlrohrs eine schnelle Aufheizung des Materials bei gleichzeitig reduziertem Brennstoffverbrauch. Dies führt zu einer signifikanten Senkung der Betriebskosten sowie der CO₂- und NOₓ-Emissionen. Die modulare Bauweise des Systems erleichtert zudem Wartung und Austausch einzelner Komponenten.

Alternativ können Strahlrohre auch elektrisch betrieben werden. Das Strahlrohr besteht in diesem Fall aus einem hitzebeständigen Hüllkörper, in dem elektrische Heizelemente integriert sind. Diese erzeugen durch Widerstandserwärmung thermische Energie, die über die Rohrwandung in Form von Strahlung auf das vorbeigeführte Bandmaterial übertragen wird. Temperatursensoren und eine elektronische Regelung ermöglichen eine präzise Steuerung der Heizleistung. Eine äußere Isolierung minimiert Wärmeverluste.

Das System arbeitet vollständig emissionsfrei, da keine fossilen Brennstoffe verwendet werden. Es bietet eine gleichmäßige Temperaturverteilung, schnelle Reaktionszeiten und einen geringen Wartungsaufwand. Die modulare Bauweise erlaubt eine flexible Integration in bestehende Anlagen und unterstützt eine energieeffiziente, umweltfreundliche Produktion.

Alternativ wird die Heizeinheit mittels offener Flammen betrieben. Dabei wird das Bandmaterial direkt oder indirekt durch die Strahlungs- und Konvektionswärme der Flamme erhitzt. Die offene Flamme wird durch die kontrollierte Verbrennung eines Gas-Luft-Gemisches erzeugt, wobei die Flammenführung so gestaltet ist, dass eine gleichmäßige Temperaturverteilung über die Bandbreite erreicht wird.

Ein wesentlicher Vorteil der offenen Flammenbeheizung liegt in der hohen Leistungsdichte und der schnellen Wärmeübertragung, wodurch kurze Aufheizzeiten und hohe Durchsatzraten ermöglicht werden. Die direkte Flammenwirkung erlaubt eine flexible Anpassung an unterschiedliche Banddicken und -geschwindigkeiten. Zudem ist die Technologie robust, bewährt und kosteneffizient in der Anschaffung und im Betrieb. Durch die gezielte Steuerung der Flammenintensität und -verteilung kann die Temperaturführung präzise geregelt werden, was die thermische Belastung des Materials minimiert und die Produktqualität verbessert.

Die offene Flammenbeheizung eignet sich insbesondere für Prozesse, bei denen hohe Temperaturen in kurzer Zeit erforderlich sind, und stellt eine wirtschaftliche Lösung für die kontinuierliche Warmbanderwärmung dar.

Bei einer bevorzugten Ausgestaltung der Produktionsanlage ist die Einlauf-Vakuumschleuse als barometrische Flüssigkeitsschleuse ausgeführt, bei der der Druckausgleich durch eine barometrische Flüssigkeitssäule erfolgt. Ein Beispiel für den Aufbau einer barometrischen Flüssigkeitsschleuse findet sich in der WO 2019/122131 A1. Dies hat beispielsweise den Vorteil, dass die barometrische Flüssigkeitsschleuse gleichzeitig als Spülstation nach der Beize fungiert. Entsprechend ist das Verfahren derart weitergebildet, dass die Einlauf-Vakuumschleuse der PVD-Beschichtungsanlage als barometrische Flüssigkeitsschleuse ausgeführt ist, so dass das Warmband in der Einlauf-Vakuumschleuse gleichzeitig gereinigt wird und in einen Bereich mit reduziertem Druck eingebracht wird. Bei einer bevorzugten Ausgestaltung umfasst die Flüssigkeitsschleuse mindestens zwei hintereinandergeschaltete Flüssigkeitsstufen.

Die Auswahl einer barometrischen Flüssigkeitsschleuse als Einlauf-Vakuumschleuse beruht dabei nicht auf einer beliebigen Auswahl einer bekannten Schleusenbauart. Vielmehr hat sich gezeigt, dass gerade eine Flüssigkeitsschleuse in der vorliegenden Prozessführung besonders geeignet ist, weil sie an der Schnittstelle zwischen dem Beizen des Warmbands und dem Einbringen des Warmbands in den Bereich mit reduziertem Druck nicht nur eine Drucktrennung bewirken kann, sondern zugleich eine flüssigkeitsgestützte Oberflächenbehandlung des Warmbands ermöglicht. Die barometrische Flüssigkeitsschleuse ist damit im vorliegenden Zusammenhang nicht nur als Schleusenelement, sondern als funktionell auf den Gesamtprozess abgestimmte Prozesskomponente ausgebildet.

Nach dem Beizprozess ist ein Spülen des Warmbandes erforderlich, um alle Rückstände der Beizlösung vollständig zu entfernen. Während des Beizens werden Verunreinigungen wie Rost und Zunder durch Säuren gelöst und von der Oberfläche des Warmbandes entfernt. Diese Säuren und die gelösten Verunreinigungen müssen gründlich abgespült werden, um eine anhaltende Säurereaktion zu verhindern, die das Material beschädigen könnte. Ein gründliches Spülen stellt sicher, dass keine Säurereste auf der Oberfläche verbleiben, die die nachfolgende Beschichtung beeinträchtigen könnten. Rückstände könnten die Haftung der Beschichtung verschlechtern und zu Korrosionsproblemen führen. Zudem sorgt das Spülen für eine saubere und reaktive Oberfläche, die für eine gleichmäßige und qualitativ hochwertige Beschichtung unerlässlich ist.

Hier zeigt sich, dass die Wahl einer barometrischen Flüssigkeitsschleuse über die bloße Bereitstellung einer bekannten Einlauf-Vakuumschleuse hinausgeht. Die Flüssigkeitssäule der Flüssigkeitsschleuse dient nicht nur der Drucktrennung gegenüber dem Bereich mit reduziertem Druck, sondern stellt zugleich das Medium bereit, durch das das Warmband an derselben Prozessstelle gereinigt wird. Durch die Verwendung der barometrischen Flüssigkeitsschleuse werden somit Schleusenfunktion und Reinigungsfunktion in einem gemeinsamen Aggregat realisiert. Dies führt zu einer synergistischen Wirkung, weil die für die Drucktrennung eingesetzte Flüssigkeit gleichzeitig zur Abreinigung von Beizrückständen genutzt wird.

Bei einer bevorzugten Ausgestaltung der Produktionsanlage bildet die als barometrische Flüssigkeitsschleuse ausgebildete Einlauf-Vakuumschleuse die erste (insbesondere einzige) Spülstation nach der Beize. Entsprechend ist das Verfahren derart weitergebildet, dass die Reinigung in der Einlauf-Vakuumschleuse das erste (insbesondere einzige) Spülen des Warmbandes nach dem Beizen darstellt.

Gerade bei dieser Ausgestaltung wird deutlich, dass die Auswahl der barometrischen Flüssigkeitsschleuse nicht auf dem Austausch einer ersten Schleusenbauart gegen eine andere Schleusenbauart beruht. Vielmehr wird die barometrische Flüssigkeitsschleuse so ausgewählt, dass sie die erste und bevorzugt die einzige Spülstation nach der Beize bildet. Die barometrische Flüssigkeitsschleuse übernimmt damit an derselben Prozessstelle sowohl die Funktion des Spülens des Warmbands als auch die Funktion des Einbringens des Warmbands in den Bereich mit reduziertem Druck. Die Auswahl der Flüssigkeitsschleuse führt hierdurch zu einer funktionellen Verdichtung der Prozessschritte, die mit einer rein mechanischen oder hiervon getrennten Schleusenlösung nicht in gleicher Weise erreicht wird.

Der Einsatz einer barometrischen Flüssigkeitsschleuse als Einlauf-Vakuumschleuse nach dem Beizprozess bietet mehrere entscheidende Vorteile: Die barometrische Flüssigkeitsschleuse ermöglicht eine gründliche Spülung des Warmbandes direkt nach dem Beizen. Dadurch werden alle Rückstände der Beizlösung vollständig entfernt, was eine anhaltende Säurereaktion verhindert und die Oberfläche des Warmbandes optimal für die nachfolgende Beschichtung vorbereitet. Durch die unmittelbare Überführung des Warmbandes in den Bereich mit reduziertem Druck nach der Spülung wird eine Oxidation der Oberfläche verhindert. Dies ist besonders wichtig, da oxidierte Oberflächen die Haftung und Qualität der Beschichtung beeinträchtigen können. Die barometrische Flüssigkeitsschleuse stellt sicher, dass das Warmband in einem optimalen Zustand für die Beschichtung bleibt. Die Integration der Spülstation in die Vakuumschleuse reduziert die Anzahl der erforderlichen Prozessschritte und Anlagenkomponenten. Dies führt zu einer Vereinfachung des Produktionsprozesses und einer Reduzierung der Investitions- und Betriebskosten. Zudem wird der Platzbedarf minimiert, was die Effizienz der Produktionslinie erhöht. Die barometrische Flüssigkeitsschleuse ermöglicht eine präzise Kontrolle der Spülparameter und der Übergangsbedingungen in das Vakuum. Dies trägt zur Konsistenz und Qualität der Beschichtung bei, da die Bedingungen für die Beschichtung optimal eingestellt werden können. Diese Vorteile machen die barometrische Flüssigkeitsschleuse zu einer entscheidenden Komponente in der Prozesskette der Warmbandbeschichtung und tragen wesentlich zur Effizienz und Qualität des gesamten Beschichtungsprozesses bei.

Bei einer speziellen Ausgestaltung der Produktionsanlage umfasst die Produktionsanlage zwischen der Beize und der als barometrische Flüssigkeitsschleuse ausgebildeten Einlauf-Vakuumschleuse eine Spülstation für das gebeizte Warmband. Entsprechend ist das Verfahren in einer speziellen Ausgestaltung derart weitergebildet, dass das Warmband nach dem Beizen gespült wird und anschließend über die als barometrische Flüssigkeitsschleuse ausgeführte Einlauf-Vakuumschleuse in den Bereich mit reduziertem Druck verbracht wird, wobei in der Einlauf-Vakuumschleuse eine weitere Reinigung des Warmbandes erfolgt. Auch in dieser alternativen Ausgestaltung ist die barometrische Flüssigkeitsschleuse nicht lediglich als von der Oberflächenbehandlung des Warmbands getrenntes Schleusenelement zu verstehen. Vielmehr wird die barometrische Flüssigkeitsschleuse auch hier so ausgewählt, dass sie neben der Drucktrennung eine weitere Reinigung des Warmbands bewirken kann. Die Auswahl der Flüssigkeitsschleuse führt somit auch in dieser Ausgestaltung zu einer technischen Mehrfachfunktion der Einlauf-Vakuumschleuse.

Die Kombination einer konventionellen Spülstation nach dem Beizprozess und einer barometrische Flüssigkeitsschleuse, die eine weitere Spülung durchführt, bietet mehrere Vorteile. Zunächst ermöglicht die konventionelle Spülstation eine gründliche Entfernung der Beizrückstände und Verunreinigungen, die während des Beizprozesses entstanden sind. Dies stellt sicher, dass die Oberfläche des Warmbandes frei von Säureresten und anderen Rückständen ist, die die Qualität der nachfolgenden Beschichtung beeinträchtigen könnten. Die anschließende barometrische Flüssigkeitsschleuse bietet eine zusätzliche Spülung, die nicht nur die verbleibenden Rückstände entfernt, sondern auch eine kontrollierte Übergabe des Warmbandes in den Bereich mit reduziertem Druck ermöglicht. Diese doppelte Spülung sorgt für eine besonders saubere und reaktive Oberfläche, die für eine hochwertige Beschichtung erforderlich ist. Zudem verhindert die barometrische Flüssigkeitsschleuse eine Oxidation des Warmbandes, da es unmittelbar nach der Spülung in das Vakuum überführt wird. Dies trägt zur Verbesserung der Haftung und Qualität der Beschichtung bei und reduziert die Notwendigkeit weiterer Prozessschritte.

Bei einer speziellen Ausgestaltung der Produktionsanlage ist die Einlauf-Vakuumschleuse als barometrische Flüssigkeitsschleuse ausgeführt, in die die Beize integriert ist. In einem solchen Fall umfasst die Produktionsanlage zur Herstellung von beschichtetem Warmband:
a) Eine Warmband-Produktionslinie zur Erzeugung von Warmband,
b) eine PVD-Beschichtungsanlage zur Aufbringung einer Beschichtung auf das Warmband mit einer Einlauf-Vakuumschleuse,
wobei die Einlauf-Vakuumschleuse als barometrische Flüssigkeitsschleuse ausgeführt ist, bei der der Druckausgleich durch eine barometrische Flüssigkeitssäule erfolgt, und wobei die Flüssigkeitsschleuse als Beize ausgeführt ist zur Entfernung von Oxidschichten und Verunreinigungen von der Oberfläche des Warmbands. Weiterhin ist auch hier eine durchgehende Bandführung durch die Beize und durch die PVD-Beschichtungsanlage mit den zuvor beschriebenen Vorteilen vorgesehen. Da die Beize in einem solchen Fall in die Einlauf-Vakuumschleuse der PVD-Beschichtungsanlage integriert ist, ergibt sich automatisch eine durchgehende Bandführung durch die Beize und die PVD-Beschichtungsanlage.

Auch in dieser Ausgestaltungsgruppe beruht die Wahl der barometrischen Flüssigkeitsschleuse nicht auf einer beliebigen Auswahl einer bekannten Schleusenbauart. Die barometrische Flüssigkeitsschleuse wird hier vielmehr so ausgewählt und ausgelegt, dass sie neben der Schleusenfunktion zugleich eine Beizfunktion für das Warmband übernimmt. Die Flüssigkeitsschleuse dient damit nicht nur der Drucktrennung, sondern zugleich derjenigen Oberflächenbehandlung, durch die Oxidschichten und Verunreinigungen vor dem Beschichtungsschritt entfernt werden.

In dieser Ausführung wird das Warmband während des Schleusenvorgangs mit einem geeigneten Beizmedium behandelt, wodurch Oxid- und Zunderschichten effektiv entfernt werden. Dies gewährleistet eine metallisch reine Oberfläche, die eine optimale Haftung der nachfolgenden PVD-Beschichtung ermöglicht. Durch die Integration des Beizprozesses in die Schleusenfunktion wird der Anlagenaufbau kompakter, separate Reinigungsstufen entfallen und der Materialdurchlauf bleibt kontinuierlich. Zudem trägt die flüssigkeitsbasierte Schleusentechnologie zur Abdichtung gegenüber dem Vakuumbereich bei, ohne bewegliche mechanische Komponenten, was die Betriebssicherheit erhöht und den Wartungsaufwand reduziert.

Bei einer bevorzugten Ausgestaltung umfasst die Flüssigkeitsschleuse mindestens zwei hintereinandergeschaltete Flüssigkeitsstufen, wobei eine erste Stufe als Beizeinrichtung zur Entfernung von Oberflächenoxiden des durchgeführten Warmbandes ausgebildet ist und eine nachgeschaltete zweite Stufe ein Spülmedium enthält, das zur Abreinigung von Beizrückständen dient.

Gerade bei dieser Ausgestaltung wird die technische Besonderheit der ausgewählten Flüssigkeitsschleuse besonders deutlich. Die barometrische Flüssigkeitsschleuse ist hier nicht nur zum Einbringen des Warmbands in den Bereich mit reduziertem Druck ausgebildet, sondern weist eine funktionelle Staffelung auf, in der in einer ersten Flüssigkeitsstufe eine Beizfunktion und in einer nachgeschalteten zweiten Flüssigkeitsstufe eine Spülfunktion verwirklicht ist. Die Auswahl der Flüssigkeitsschleuse führt damit zu einer synergistischen Zusammenfassung von Beizen, Spülen und Schleusen in einer gemeinsamen Prozesskomponente bzw. in einer gemeinsamen Aggregatfolge. Hierdurch kann die Schnittstelle zwischen Oberflächenbehandlung des Warmbands und Vakuumeintritt besonders kompakt ausgebildet werden. Zugleich kann das Warmband nach der Beizbehandlung und der nachgeschalteten Entfernung von Beizrückständen ohne Zwischenlagern und ohne Unterbrechen des Bandlaufs in den Bereich mit reduziertem Druck überführt werden. Die Auswahl der Flüssigkeitsschleuse führt damit in dieser Ausgestaltung zu einer besonders engen prozesstechnischen Kopplung von Vorbehandlung und Beschichtungsprozess.

Diese Konfiguration ermöglicht eine integrierte Vorbehandlung des Warmbandes unmittelbar vor dem Eintritt in den Vakuumbereich, wodurch Oxid- und Zunderschichten entfernt und verbleibende Beizrückstände zuverlässig abgespült werden. Die Kombination aus Beizen und Spülen innerhalb der Schleuse gewährleistet eine metallisch saubere und kontaminationsfreie Oberfläche, die eine optimale Haftung der nachfolgenden Vakuumbeschichtung, insbesondere mittels physikalischer Gasphasenabscheidung (PVD), sicherstellt. Gleichzeitig bleibt die Schleusenfunktion zur Drucktrennung erhalten, ohne dass zusätzliche Prozesskammern oder mechanische Schleusenelemente erforderlich sind. Dies führt zu einem kompakten, energieeffizienten und wartungsarmen Anlagenkonzept mit reduziertem Platzbedarf und hoher Prozessintegration.

Analog zur Produktionsanlage umfasst das Verfahren zur Herstellung von beschichtetem Warmband die Schritte:
a) Erzeugen von Warmband in einer Warmband-Produktionslinie,
b) Verbringen des Warmbandes in einen Bereich mit reduziertem Druck über eine Einlauf-Vakuumschleuse, die als Flüssigkeitsschleuse ausgebildet ist,
c) Beschichten des Warmbands mittels Physical Vapor Deposition (PVD) in einer PVD-Beschichtungsanlage umfassend die Einlauf-Vakuumschleuse,

wobei das Warmband in der als Flüssigkeitsschleuse ausgebildeten Einlauf-Vakuumschleuse gebeizt wird, um Oxidschichten und Verunreinigungen von der Oberfläche zu entfernen,
wobei das Warmband durchgehend durch die als Beize ausgebildete Flüssigkeitsschleuse und die PVD-Beschichtungsanlage geführt wird.

Bei einer bevorzugten Ausgestaltung umfasst die Flüssigkeitsschleuse mindestens zwei hintereinandergeschaltete Flüssigkeitsstufen, wobei das Warmband in der ersten Stufe gebeizt wird und in einer nachgeschalteten zweiten Stufe gespült wird, um Beizrückstände abzureinigen.

Die Vorteile dieser Verfahren entsprechen den Vorteilen, die in Bezug auf die entsprechende Anlage erläutert wurden.

Zusammenfassend ist die Auswahl einer barometrischen Flüssigkeitsschleuse als Einlauf-Vakuumschleuse im vorliegenden Zusammenhang nicht als bloße Auswahl eines bekannten Schleusentyps zu verstehen. Vielmehr wird die barometrische Flüssigkeitsschleuse in Abhängigkeit von der jeweiligen Ausgestaltung so gewählt, dass sie neben der Schleusenfunktion eine zusätzliche technische Funktion an der Schnittstelle zwischen Beize und PVD-Beschichtungsanlage übernimmt, insbesondere eine Spülfunktion, eine weitere Reinigungsfunktion und/oder eine Beizfunktion. Die Auswahl der Flüssigkeitsschleuse führt dadurch zu einer funktionellen Integration mehrerer Prozessschritte und zu den vorstehend erläuterten technischen Effekten.

Alternativ zur barometrischen Flüssigkeitsschleuse kann die Einlauf-Vakuumschleuse als Rollenschleuse realisiert sein. Möglich sind auch eine Einlauf-Vakuumschleuse in Form einer Kombination von mehreren Schleusen in Form von Schleusenstufen, die den Druck stufenweise verringern. Bevorzugt ist dann eine der Schleusen der Kombination von mehreren Schleusen als barometrische Flüssigkeitsschleuse ausgeführt mit den obenstehenden Vorteilen.

Bei einer bevorzugten Ausgestaltung umfasst die Produktionsanlage zwischen der Beize und der PVD-Beschichtungsanlage ein Dressiergerüst und/oder ein Dressiergerüst stromabwärts der PVD-Beschichtungsanlage. Entsprechend ist das Verfahren bevorzugt derart weitergebildet, dass das Warmband nach dem Beizen und vor dem Beschichten dressiert wird und/oder das Warmband nach dem Beschichten dressiert wird.

Ein Dressieren des Warmbandes zwischen dem Beizen und dem Beschichten bietet mehrere Vorteile. Zunächst wird durch das Dressieren die Oberflächenqualität des Warmbandes verbessert, indem Unebenheiten und Verformungen, die während des Beizprozesses entstanden sind, geglättet werden. Dies führt zu einer gleichmäßigeren und glatteren Oberfläche, die eine bessere Haftung der nachfolgenden Beschichtung ermöglicht. Zudem kann das Dressieren Spannungen im Material abbauen, die durch den Beizprozess entstanden sind, wodurch die mechanischen Eigenschaften des Warmbandes verbessert werden. Eine gleichmäßige Oberfläche ist besonders wichtig für die Qualität der Beschichtung, da sie eine gleichmäßige Schichtdicke und eine bessere Haftung gewährleistet.

Das Dressieren des Warmbandes nach dem Beschichten bietet ebenfalls wichtige Vorteile. Durch das Dressieren nach der Beschichtung wird die Oberflächenrauheit der Beschichtung reduziert, was zu einer verbesserten Ästhetik und Funktionalität führt. Zudem können durch das Dressieren nach der Beschichtung eventuelle Unregelmäßigkeiten und Defekte in der Beschichtung ausgeglichen werden, was die Qualität und Haltbarkeit der Beschichtung erhöht. Das Dressieren nach der Beschichtung kann auch dazu beitragen, die Haftung der Beschichtung zu verbessern, indem es die Oberfläche verdichtet und eventuelle Poren oder Mikrorisse schließt. Insgesamt trägt das Dressieren nach der Beschichtung zur Verbesserung der Oberflächenqualität und der mechanischen Eigenschaften des beschichteten Warmbandes bei.

Bei einer weitergebildeten Variante des Verfahrens ist die Beschichtungstemperatur des Warmbandes beim Beschichten größer 100 °C, bevorzugt größer 120 °C, besonders bevorzugt größer 150 °C, insbesondere größer 200 °C und/oder kleiner 300 °C, bevorzugt kleiner 250 °C.

Die Beschichtungstemperatur des Warmbandes hat einen erheblichen Einfluss auf die Qualität und Eigenschaften der resultierenden Beschichtung. Wenn die Beschichtungstemperatur größer als 100 °C, bevorzugt größer als 120 °C und besonders bevorzugt größer als 150 °C ist, ergeben sich mehrere Vorteile. Höhere Temperaturen fördern die Diffusion von Atomen an der Grenzfläche zwischen dem Warmband und der Beschichtung, was zu einer besseren Haftung der Beschichtung führt. Dies ist besonders wichtig für die mechanische Stabilität und Langlebigkeit der Beschichtung. Zudem können sich bei höheren Temperaturen innere Spannungen, die während des Beschichtungsprozesses entstehen, besser abbauen, was zu einer geringeren Wahrscheinlichkeit von Rissen und Abplatzungen in der Beschichtung führt. Höhere Temperaturen ermöglichen auch eine gleichmäßigere Verteilung der Beschichtungsmaterialien, was zu einer homogeneren Schichtstruktur führt und die mechanischen und korrosionsbeständigen Eigenschaften der Beschichtung verbessert.

Wenn die Beschichtungstemperatur kleiner als 300 °C, bevorzugt kleiner als 250 °C ist, ergeben sich ebenfalls spezifische Vorteile. Niedrigere Temperaturen verhindern unerwünschte Gefügeveränderungen im Warmband, die die mechanischen Eigenschaften des Grundmaterials beeinträchtigen könnten. Dies ist besonders wichtig für Stähle, die empfindlich auf Temperaturänderungen reagieren. Bei niedrigeren Beschichtungstemperaturen bleiben die ursprünglichen Materialeigenschaften des Warmbandes weitgehend erhalten, was vorteilhaft ist, wenn die mechanischen Eigenschaften des Grundmaterials für die Endanwendung entscheidend sind. Zudem reduzieren niedrigere Temperaturen die thermische Belastung des Warmbandes und der Beschichtungsanlage, was zu einer längeren Lebensdauer der Anlage und geringeren Betriebskosten führt. Diese Temperaturbereiche bieten somit eine optimale Balance zwischen der Verbesserung der Beschichtungseigenschaften und der Erhaltung der Materialintegrität des Warmbandes.

Bei einer speziellen Weiterbildung des Verfahrens erfolgt das Beschichten des Warmbandes in einem Beschichtungsbereich der PVD-Beschichtungsanlage, wobei der Druck im Beschichtungsbereich mindestens 1 mbar, bevorzugt mindestens 10 mbar, insbesondere mindestens 30 mbar beträgt. Weiterhin bevorzugt beträgt der Druck im Beschichtungsbereich maximal 500 mbar, insbesondere maximal 200 mbar, bevorzugt maximal 100 mbar, bevorzugt maximal 50 mbar. Entsprechend ist die Produktionsanlage bevorzugt so weitergebildet, dass die PVD-Beschichtungsanlage einen Beschichtungsbereich umfasst, wobei der Druck im Beschichtungsbereich mindestens 1 mbar, bevorzugt mindestens 10 mbar beträgt, insbesondere mindestens 30 mbar. Weiterhin bevorzugt beträgt der Druck im Beschichtungsbereich maximal 500 mbar, insbesondere maximal 200 mbar, bevorzugt maximal 100 mbar, bevorzugt maximal 50 mbar.

Ein Beispiel für eine PVD-Beschichtungsanlage, die in diesem Druckbereich arbeitet, ist in der WO 2016/042079 A1 erläutert.

Diese Druckbedingungen bieten verschiedene Vorteile. Ein höherer Druck reduziert die Anforderungen an die Vakuumerzeugung, was die Betriebskosten senkt und die Integration der Anlage in bestehende Produktionslinien erleichtert. Insbesondere ermöglichen diese Druckbedingungen den Einsatz der zuvor erwähnten barometrischen Flüssigkeitsschleuse als Einlauf-Vakuumschleuse. Herkömmliche Hochvakuum-PVD-Anlagen erfordern aufgrund des niedrigeren Druckbereichs eine andere Schleusentechnik. Die barometrische Flüssigkeitsschleuse wiederum kann gleichzeitig als Spülstation dienen, wie zuvor erläutert wurde.

Bei einer bevorzugten Weiterbildung der Produktionsanlage bzw. des Verfahrens enthält der Beschichtungsbereich eine Schutzgas-Atmosphäre. Bevorzugt weist die Schutzgas-Atmosphäre einen Sauerstoffanteil von weniger als 5 Vol.-%, bevorzugt weniger als 2 Vol.-%, insbesondere weniger als 1 Vol.-% auf. Diese Ausgestaltung bietet mehrere Vorteile. Ein niedriger Sauerstoffanteil in der Schutzgas-Atmosphäre verhindert die Oxidation des Warmbandes während des Beschichtungsprozesses, was zu einer verbesserten Haftung und Qualität der Beschichtung führt. Oxidationsprozesse können die Oberflächenstruktur des Warmbandes beeinträchtigen und die Bildung von Defekten in der Beschichtung begünstigen. Durch die Reduktion des Sauerstoffgehalts wird die Bildung solcher Defekte minimiert, was die mechanischen und korrosionsbeständigen Eigenschaften der Beschichtung verbessert. Zudem trägt eine sauerstoffarme Schutzgas-Atmosphäre zur Verlängerung der Lebensdauer der Beschichtungsanlage bei, da weniger oxidative Schäden an den Anlagenteilen auftreten. Dies reduziert die Wartungs- und Betriebskosten und erhöht die Effizienz der Produktionslinie. Die Verwendung einer Schutzgas-Atmosphäre mit einem niedrigen Sauerstoffanteil ermöglicht auch eine präzisere Kontrolle der Beschichtungsparameter, was zu einer gleichmäßigeren und qualitativ hochwertigeren Beschichtung führt

Die Schutzgas-Atmosphäre ist bevorzugt eine Inertgas-Atmosphäre, insbesondere eine StickstoffAtmosphäre und/oder eine Argon-Atmosphäre, das heißt die Schutzgas-Atmosphäre besteht ausschließlich aus einem Inertgas, insbesondere Stickstoff oder Argon oder einer Mischung von Stickstoff und Argon und technisch unvermeidbaren Verunreinigungen. Alternativ ist die Schutzgas-Atmosphäre eine Inertgas-Atmosphäre mit Wasserstoffbeimischung. In diesem Fall besteht die Schutzgas-Atmosphäre aus bis zu 8 Vol.-% Wasserstoff, Rest Inertgas (insbesondere Stickstoff oder Argon oder eine Mischung aus Stickstoff und Argon) und technisch unvermeidbaren Verunreinigungen.

Näher erläutert wird die Erfindung anhand der Beispiele und Figuren.

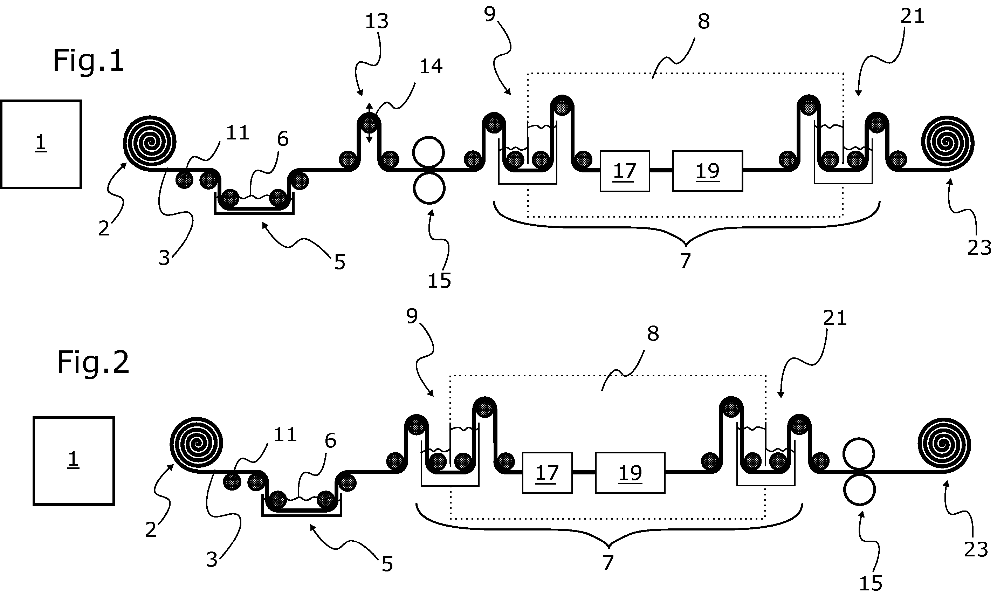

**Figur** 1 zeigt eine erste schematische Darstellung der erfindungsgemäßen Produktionsanlage. Die Produktionsanlage umfasst eine Warmband-Produktionslinie 1 in Form einer Warmbandstraße zur Erzeugung von Warmband 3. Am Ende der Warmband-Produktionslinie 1 wird das Warmband gehaspelt, um es zwischenzulagern und zu transportieren. Weiterhin umfasst die Produktionsanlage eine Haspel 2, eine Beize 5 und eine PVD-Beschichtungsanlage 7 mit einer Einlauf-Vakuumschleuse 9. Das in der Warmband-Produktionslinie 1 erzeugte Warmband wird als Coil zur Haspel 2 transportiert, dort abgehaspelt und in die durchgehende Bandführung eingeführt. Nachfolgend im Bandlauf folgt die Beize 5. Die Beize 5 ist schematisch als ein Tauchbecken dargestellt. Selbstverständlich kann die Beize 5 auch als ein Coil Coater ausgeführt sein, der das Warmband mit der Beizlösung belegt oder als eine Sprüheinrichtung, in der das Warmband mit der Beizlösung besprüht wird. Die Produktionsanlage weist eine durchgehende Bandführung von der Haspel 2 durch die Beize 5 und die PVD-Beschichtungsanlage 7 auf. Das Warmband 3 wird mittels diverser Rollen und Umlenkrollen 11 in bekannter Weise geführt. Der Übersichtlichkeit halber ist nur die erste dieser Rollen/Umlenkrollen mit dem Bezugszeichen 11 versehen.

Entlang der Produktionsroute sind angeordnet:
- eine Warmband-Produktionslinie 1 zur Erzeugung des Warmbandes
- eine Haspel 2
- eine Beize 5
- ein Bandspeicher 13
- ein Dressiergerüst 15
- eine Einlauf-Vakuumschleuse 9
- eine Heizeinheit 17
- ein Beschichtungsbereich 19
- eine Auslauf-Vakuumschleuse 21
- eine Haspel 23

In der Beize 5 wird das Warmband 3 durch ein Säurebad 6 geführt, um den beim Warmwalzen entstandenen Zunder zu entfernen.

Zwischen der Beize 5 und der Einlauf-Vakuumschleuse 9 ist der Bandspeicher 13 angeordnet. Im Bandspeicher wird das Warmband 3 über eine Vielzahl von Umlenkrollen in mehreren Schlaufen geführt wird. In Figur 1 ist der Bandspeicher 13 vereinfacht durch die bewegliche Umlenkrolle 14 symbolisiert. Durch das Bewegen der Umlenkrolle 14 entlang der Pfeilrichtung wird die Länge der Schlaufe und damit die Länge des Bandlaufes verändert. Somit kann eine gewisse Bandlänge in der Schlaufe zwischengepuffert werden.

Zwischen der Beize 5 und der PVD-Beschichtungsanlage 7 befindet sich ein Dressiergerüst 15. In Figur 1 ist das Dressiergerüst 15 stromabwärts des Bandspeicher 13 angeordnet. Eine umgekehrte Anordnung ist ebenfalls möglich. Das Dressiergerüst 15 ermöglicht eine Verbesserung der Oberflächenqualität vor dem nachfolgenden Beschichten. Das Dressiergerüst 15 ist durch zwei sich gegenüberliegen Rollen symbolisiert, mit denen Druck auf das Warmband 3 ausgeübt werden kann.

An das Dressiergerüst 15 schließt sich die PVD-Beschichtungsanlage 7 an. Diese beginnt mit der der Einlauf-Vakuumschleuse 9. Die Einlauf-Vakuumschleuse 9 ist als barometrische Flüssigkeitsschleuse ausgeführt. Durch die unterschiedlich hohen Flüssigkeitssäulen ergibt sich ein Bereich 8 mit reduziertem Druck. Der Bereich 8 mit reduziertem Druck ist in Figur 1 durch die gestrichelten Linien angedeutet.

Innerhalb des Bereiches 8 mit reduziertem Druck ist eine Heizeinheit 17 angeordnet, in der das Warmband 3 auf eine Beschichtungstemperatur erwärmt wird, bevor es in dem Beschichtungsbereich 19 mittels PVD beschichtet wird.

Nach dem Beschichten wird das Warmband 3 über die Auslauf-Vakuumschleuse 21 aus dem Bereich 8 mit reduziertem Druck in Umgebungsatmosphäre verbracht. Vorliegend wird ist auch die Auslauf-Vakuumschleuse 21 als barometrische Flüssigkeitsschleuse ausgeführt.

Anschließend wird das Warmband 3 mittels der Haspel 23 zu Coils aufgewickelt.

Die weiteren Figuren 2-4 zeigen weitere Ausführungsvarianten. Dabei bezeichnen gleiche Bezugszeichen gleiche Objekte. In den jeweiligen Figurenbeschreibungen wird nur auf die Unterschiede zu Figur 1 eingegangen.
**Figur** 2 zeigt eine Ausführungsform, in der ein Einlauf-Vakuumschleuse 9 unmittelbar auf die Beize 5 folgt, ohne dass ein Aggregat dazwischen angeordnet ist. Auf den Bandspeicher 13 wurde dabei verzichtet. Die Einlauf-Vakuumschleuse 9 bildet zudem die erste Spülstation nach der Beize 5. Das Dressiergerüst 15 ist in diesem Fall nach der PVD-Beschichtungsanlage 7 und vor der Haspel 23 angeordnet.

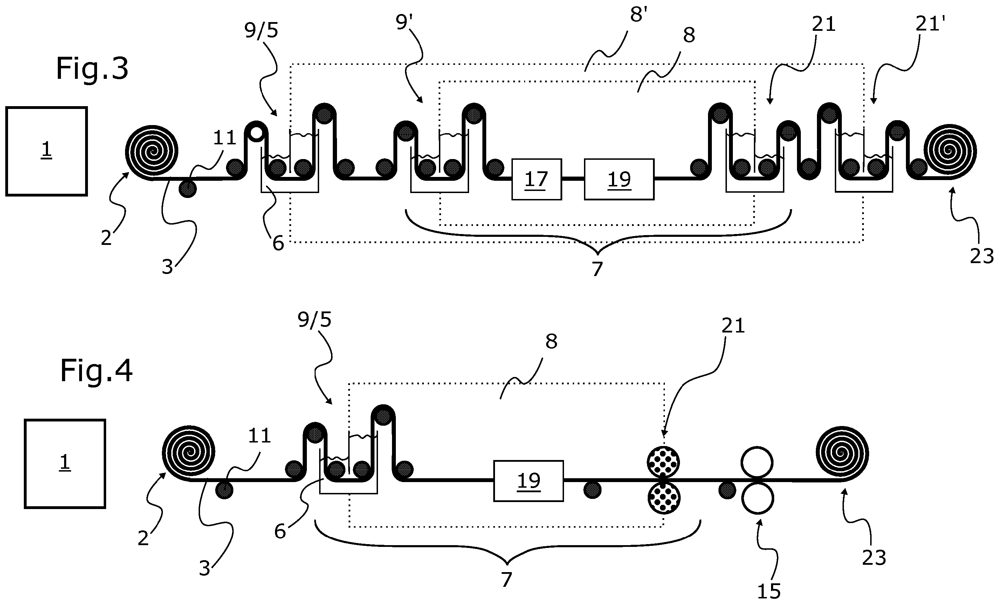

**Figur** 3 zeigt eine Ausführungsform, bei der die Einlauf-Vakuumschleuse 9 in Form einer Kombination von mehreren Schleusen in Form von Schleusenstufen ausgeführt ist, die den Druck stufenweise verringern. Die erste Einlauf-Vakuumschleuse 9 führt zu einer ersten Druckreduzierung im Bereich 8'. Die zweite Einlauf-Vakuumschleuse 9' führt in den Bereich 8 mit noch weiter reduziertem Druck. Entsprechend sind auch zwei Auslauf-Vakuumschleusen 21 und 21' vorgesehen. Alle Vakuumschleusen sind als barometrische Flüssigkeitsschleusen ausgeführt. Die erste Einlauf-Vakuumschleuse 9 bildet zudem gleichzeitig die Beize 5, indem die Flüssigkeit in der Flüssigkeitsschleuse eine Beizlösung ist. In der Flüssigkeitsschleuse befindet sich also das Säurebad 6. Die zweite Einlauf-Vakuumschleuse 9' dient gleichzeitig als Spülstation und entfernt Reste der Beizlösung vom Warmband 3.
**Figur** 4 zeigt eine Ausführungsform mit nur einer Einlauf-Vakuumschleuse 9, die gleichzeitig die Beize 5 bildet. Bei dieser Ausführungsform ist auf die Heizeinheit 17 verzichtet worden. Die Auslauf-Vakuumschleuse 21 ist hier als Rollenschleuse realisiert.

### Bezugszeichenliste

- 1: Warmband-Produktionslinie zur Erzeugung von Warmband
- 2: Haspel
- 3: Warmband
- 5: Beize zur Entfernung von Oxidschichten und Verunreinigungen
- 6: Säurebad innerhalb der Beize
- 7: PVD-Beschichtungsanlage
- 8: Bereich mit reduziertem Druck
- 8': Bereich mit erster Druckreduzierung (bei mehrstufiger Schleuse)
- 9: Einlauf-Vakuumschleuse
- 9': Zweite Einlauf-Vakuumschleuse (bei mehrstufiger Schleuse)
- 11: Rollen und Umlenkrollen zur Bandführung
- 13: Bandspeicher
- 14: Bewegliche Umlenkrolle im Bandspeicher
- 15: Dressiergerüst
- 17: Heizeinheit
- 19: Beschichtungsbereich innerhalb der PVD-Beschichtungsanlage
- 21: Auslauf-Vakuumschleuse
- 21': Zweite Auslauf-Vakuumschleuse (bei mehrstufiger Schleuse)
- 23: Haspel zum Aufwickeln des beschichteten Warmbands

## Patentansprüche

1. Produktionsanlage zur Herstellung von beschichtetem Warmband (3), umfassend:
a) Optional eine Warmband-Produktionslinie (1) zur Erzeugung von Warmband (3),
b) eine Beize (5) zur Entfernung von Oxidschichten und Verunreinigungen von der Oberfläche des Warmbands (3),
c) eine PVD-Beschichtungsanlage (7) zur Aufbringung einer Beschichtung auf das Warmband (3) mit einer Einlauf-Vakuumschleuse (9),
**dadurch gekennzeichnet, dass** die Produktionsanlage eine durchgehende Bandführung durch die Beize (5) und die PVD-Beschichtungsanlage (7) aufweist.

2. Produktionsanlage nach Anspruch 1, **dadurch gekennzeichnet, dass** die Produktionsanlage zwischen der Beize (5) und der PVD-Beschichtungsanlage (7) keine Glüheinheit umfasst.

3. Produktionsanlage nach einem der Ansprüche 1 bis 2, **dadurch gekennzeichnet, dass** der Abstand vom Ende der Beize (5) bis zur Einlauf-Vakuumschleuse (9) der PVD-Beschichtungsanlage (7), gemessen entlang des Warmbandes (3), maximal 100 Meter beträgt.

4. Produktionsanlage nach einem der Ansprüche 1 bis 3, **dadurch gekennzeichnet, dass** die PVD-Beschichtungsanlage (7) eine Heizeinheit (17) umfasst, die zwischen der Einlauf-Vakuumschleuse (9) und einem Beschichtungsbereich (19) angeordnet ist, wobei die Heizeinheit (17) insbesondere als Induktions-Heizeinheit, Infrarot-Heizeinheit, Elektronenstrahl-Heizeinheit oder Plasma-Heizeinheit ausgeführt ist.

5. Produktionsanlage nach einem der Ansprüche 1 bis 4, **dadurch gekennzeichnet, dass** die Einlauf-Vakuumschleuse (9) als barometrische Flüssigkeitsschleuse ausgeführt ist.

6. Produktionsanlage nach einem der Ansprüche 1 bis 5, **dadurch gekennzeichnet, dass** die Produktionsanlage zwischen der Beize (5) und der PVD-Beschichtungsanlage (7) ein Dressiergerüst umfasst und/oder ein Dressiergerüst (15) stromabwärts der PVD-Beschichtungsanlage (7) umfasst.

7. Verfahren zur Herstellung von beschichtetem Warmband (3), umfassend die Schritte:
a) Erzeugen von Warmband (3) in einer Warmband-Produktionslinie (1),
b) Beizen des Warmbands (3) zur Entfernung von Oxidschichten und Verunreinigungen von der Oberfläche,
c) Verbringen des Warmbandes (3) in einen Bereich mit reduziertem Druck (8) über eine Einlauf-Vakuumschleuse (9)
d) Beschichten des Warmbands (3) mittels Physical Vapor Deposition (PVD) in einer PVD-Beschichtungsanlage (7) umfassend die Einlauf-Vakuumschleuse (9),
**dadurch gekennzeichnet, dass** das Warmband (3) durchgehend durch die Beize (5) und die PVD-Beschichtungsanlage (7) geführt wird.

8. Verfahren nach Anspruch 7, **dadurch gekennzeichnet, dass** die Temperatur des Warmbands (3) zwischen dem Beizen und dem Beschichten maximal 300 °C beträgt.

9. Verfahren nach einem der Ansprüche 7 bis 8, **dadurch gekennzeichnet, dass** die Temperatur des Warmbands (3) zwischen dem Beizen und dem Beschichten mindestens 40 °C beträgt.

10. Verfahren nach einem der Ansprüche 7 bis 9, **dadurch gekennzeichnet, dass** die Zeitdauer, in der das Warmband (3) vom Ende der Beize (5) bis zur Einlauf-Vakuumschleuse (9) der PVD-Beschichtungsanlage (7) geführt wird, maximal 30 Sekunden beträgt.

11. Verfahren nach einem der Ansprüche 7 bis 10, **dadurch gekennzeichnet, dass** Warmband (3) nach Durchlaufen der Einlauf-Vakuumschleuse (9) auf eine Beschichtungstemperatur erwärmt wird, bevor es beschichtet wird.

12. Verfahren nach einem der Ansprüche 7 bis 11, **dadurch gekennzeichnet, dass** die Einlauf-Vakuumschleuse (9) der PVD-Beschichtungsanlage (7) als barometrische Flüssigkeitsschleuse ausgeführt ist, so dass das Warmband (3) in der Einlauf-Vakuumschleuse gleichzeitig gereinigt wird und in einen Bereich mit reduziertem Druck (8) eingebracht wird.

13. Verfahren nach einem der Ansprüche 7 bis 12, **dadurch gekennzeichnet, dass** das Warmband (3) nach dem Beizen und vor dem Beschichten dressiert wird und/oder das Warmband nach dem Beschichten dressiert wird.

14. Verfahren nach einem der Ansprüche 7 bis 13, **dadurch gekennzeichnet, dass** die Beschichtungstemperatur des Warmbandes (3) beim Beschichten größer 100 °C, bevorzugt größer 120 °C, besonders bevorzugt größer 150 °C ist und/oder kleiner 300 °C, bevorzugt kleiner 250 °C ist.

15. Verfahren nach einem der Ansprüche 7 bis 14, **dadurch gekennzeichnet, dass** das Beschichten des Warmbandes (3) in einem Beschichtungsbereich (19) der PVD-Beschichtungsanlage (7) erfolgt, wobei der Druck im Beschichtungsbereich (19) mindestens 1 mbar, bevorzugt mindestens 10 mbar beträgt.
